# EUROPEAN PATENT APPLICATION

(11) **EP 2 980 595 A1**
(43) Date of publication of application: **03.02.2016**
(21) Application number: 14775842.9
(22) Date of filing: 19.03.2014
(51) Int. Cl.: G01R 31/36, H01M 10/48, H02J 7/00

(54) **BATTERY LIFE ESTIMATION METHOD AND BATTERY LIFE ESTIMATION DEVICE**

(30) Priority: 26.03.2013 JP 2013064912
(71) Applicant: Kabushiki Kaisha Toshiba, Minato-ku Tokyo 105-8001 (JP)
(72) Inventor: MORITA, Tomokazu, Minato-ku, Tokyo 105-8001 (JP); HOSHINO, Masayuki, Minato-ku, Tokyo 105-8001 (JP)
(74) Representative: Hoffmann Eitle
(86) International application number: PCT/JP2014/057499
(87) International publication number: WO 2014/156869

(57) **Abstract**

According to an embodiment, a battery life estimation method includes: calculating, for a secondary battery, battery characteristic data at a present time including at least an internal resistance value; storing use condition data including a temperature time distribution and a current value time distribution during an estimation period and a degradation characteristic map representing a distribution of degradation constants with respect to battery voltages and temperatures; and estimating a degradation amount by integrating residence times on a battery voltage temperature plane in the degradation characteristic map based on the battery characteristic data at the present time and the use condition data.

## Description

### Technical Field

Embodiments described herein relate generally to a battery life estimation method and a battery life estimation apparatus for estimating the remaining life of a secondary battery.

### Background Art

A nonaqueous electrolyte secondary battery represented by a lithium ion secondary battery has a high energy density and is used as a power supply in various kinds of portable electronic devices. In addition, examinations have been made recently concerning practical use in a hybrid car, hybrid two wheeler, electric car, and electric-motor bike. The secondary battery used in these vehicles such as cars is assumed to have an operation time of 10 to 15 years, like a car body.

When such a long life is assumed, even an electric car is expected to be traded via resale and used car purchase, like conventional gasoline-powered vehicles. For a motor vehicle with a lithium ion secondary battery, the cost of the battery accounts for a significant part of the vehicle price. Hence, when deciding the resale price or used car price of the motor vehicle, the degree of degradation and the remaining life of the battery are important. In a conventional gasoline-powered vehicle, the degree of degradation of the vehicle can be assumed within a predetermined range based on the model year and mileage. For an electric motor vehicle, however, degradation of the onboard secondary battery largely changes depending on the storage state, driving condition, charge condition, and the like even if the model year and mileage are the same.

For this reason, to establish a steady resale market for motor vehicles such as an electric car, it is probably indispensable to implement a method of diagnosing the degree of degradation of a cell and a method of estimating a remaining life as a reference to decide an objective resale price. Degradation of a vehicle's secondary battery is preferably diagnosed in a short time without requiring special equipment or facilities from the viewpoint of cost and user convenience. To meet these conditions, a method of estimating the degree of degradation by calculation based on the charge/discharge curve (voltage vs. time/current data) of a battery is examined. As one of such methods, there is disclosed a method of estimating the capacity, internal resistance, and degree of degradation of each active material of a cathode and anode in a battery by referring to the open circuit potential-charge amount data of each active material based on the charge/discharge curve (battery voltage-time data) upon charging/discharging an actual battery under a predetermined condition (for example, see patent literature 1).

### Citation List

### Patent Literatures

Patent Literature 1: Jpn. Pat. Appln. KOKAI Publication No. 2012-251806

### Summary of Invention

### Technical Problem

By a method as in patent literature 1, the values of the capacity and internal resistance of a battery can be obtained. The current degree of degradation in the battery characteristic can be diagnosed by such battery performance diagnosis. However, a method of estimating the remaining life of the secondary battery under a use condition determined as a criterion to decide the value of the battery is necessary.

It is an object of the embodiment to provide a battery life estimation method and a battery life estimation apparatus for estimating a remaining life under a predetermined use condition based on a battery characteristic at the present time.

### Solution to Problem

To achieve the above object, according to a present invention, a battery life estimation method includes: calculating, for a secondary battery, battery characteristic data at a present time including at least an internal resistance value; storing use condition data including a temperature-time distribution and a current value-time distribution during an estimation period and a degradation characteristic map representing a distribution of degradation constants with respect to battery voltages and temperatures; and estimating a degradation amount by integrating residence times on a battery voltage-temperature plane in the degradation characteristic map based on the battery characteristic data at the present time and the use condition data.

### Brief Description of Drawings

[FIG. 1] FIG. 1 is a block diagram showing the functional arrangement of a battery life estimation apparatus.
[FIG. 2] FIG. 2 is a flowchart showing the processing procedure of a calculation unit.
[FIG. 3A] FIG. 3A is a view showing a degradation characteristic map (internal resistance).
[FIG. 3B] FIG. 3B is a view showing a degradation characteristic map (capacity).
[FIG. 4A] FIG. 4A is a graph showing the estimation results of the internal resistance and capacity in a 25°C 5C cycle.
[FIG. 4B] FIG. 4B is a graph showing the estimation results of the internal resistance and capacity in a 45°C 5C cycle.
[FIG. 5] FIG. 5 is a view showing a method of calculating a battery characteristic value when a period of service is divided.
[FIG. 6A] FIG. 6A is a graph showing the estimation results of degradation amounts of the internal resistance and capacity in a 25°C 5C cycle when estimation was conducted by setting a point of the elapse of about three months as the starting point.
[FIG. 6B] FIG. 6B is a graph showing the estimation results of degradation amounts of the internal resistance and capacity in a 45°C 5C cycle when estimation was conducted by setting a point of the elapse of about three months as the starting point.
[FIG. 7A] FIG. 7A is a graph showing examples of use conditions (current values).
[FIG. 7B] FIG. 7B is a graph showing examples of use conditions (temperatures).
[FIG. 8] FIG. 8 is a graph showing a life estimation result under the use conditions shown in FIGS. 7A and 7B.
[FIG. 9A] FIG. 9A is a graph showing examples of use conditions (current values) changed in seven years.
[FIG. 9B] FIG. 9B is a graph showing examples of use conditions (temperatures) changed in seven years.
[FIG. 10] FIG. 10 is a graph showing a life estimation result when the use conditions were changed to those shown in FIGS. 9A and 9B.

### Description of Embodiments

A battery life estimation method and a battery life estimation apparatus according to the embodiment will now be described in detail with reference to the accompanying drawings.

### [Principle and Method]

In a nonaqueous electrolyte secondary battery represented by a lithium ion secondary battery, degradation in a battery characteristic progresses due to repetitive charge/discharge or storage. In a storage test under a predetermined charge state, the speed of degradation in the battery characteristic conforms to the Arrhenius law. It is therefore possible to consider that the primary cause of the degradation in the battery characteristic is a chemical side reaction that progresses in the battery. There are three probable side reactions: a decomposition reaction of an electrolyte solution on an electrode, a decomposition reaction of an active material, and a reaction of an impurity contained in an electrode or electrolyte solution.

### (Decomposition Reaction of Electrolyte Solution on Electrode)

A cathode, an anode, and an electrolyte solution exist in a battery. The cathode and the anode have electrode potentials corresponding to a charge state. The electrolyte solution is, at its interfaces, in contact with the electrodes each having an energy level difference with respect to the electrolyte solution. As one of side reactions, it is reported that a decomposition reaction of the electrolyte solution progresses on the interfaces between the electrolyte solution and the cathode and the anode, and coats are formed. This side reaction is caused by the contact between the electrolyte solution and the cathode and the anode each having an energy level difference with respect to the electrolyte solution. Hence, the speed of the side reaction probably depends on the electrode potentials that are the energy levels of the cathode and the anode. As the cathode potential rises, and the anode potential lowers, that is, as the charge of the battery progresses, the speed of this reaction increases.

### (Decomposition Reaction of Active Material)

A decomposition reaction according to the potential of an active material itself, for example, elution of an active material component or conversion to an inactive component upon an insertion or elimination reaction of Li, also occurs as a side reaction. This side reaction does not necessarily increase in speed on the battery charge side, unlike the decomposition reaction of the electrolyte solution. Degradation is sometimes prompted near a specific potential or on an overdischarge side. Hence, the relationship between the potential and the speed of the active material degradation reaction is a function that depends on the type of the active material.

### (Reaction of Impurity Contained in Electrode or Electrolyte Solution)

In the electrode or on the electrode surface, a side reaction caused by a residual impurity in an active material, for example, an alkali component such as lithium oxide or lithium carbonate or an impurity contained in the electrolyte solution, for example, water or a derivative thereof progresses. The impurity has high reactivity and high reaction speed. However, since the concentration is low, the influence on degradation is not so large in many cases.

In this embodiment, based on measurement of a battery characteristic degradation reaction speed according to a potential and temperature, degradation speed constant data of the battery characteristic on a potential-temperature plane is created, and a degradation amount is estimated based on the integral value of residence times on the potential-temperature plane calculated from battery use conditions.

### [Apparatus Arrangement]

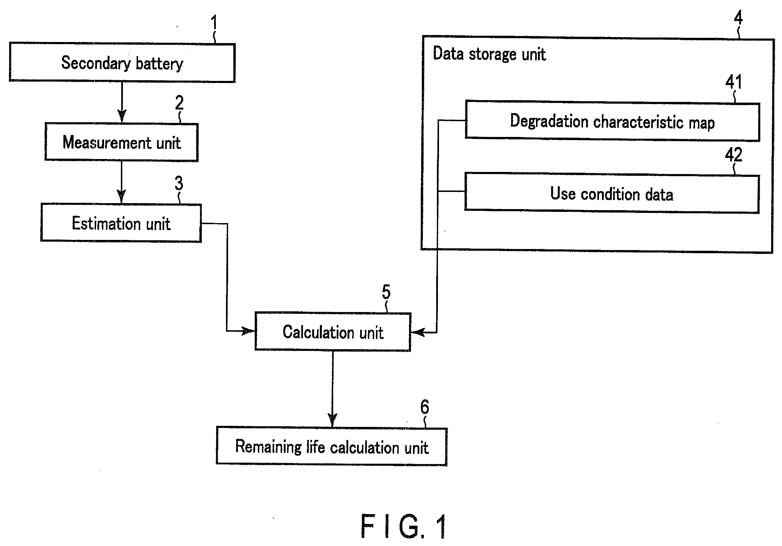

FIG. 1 is a block diagram showing the functional arrangement of a battery life estimation apparatus according to this embodiment.

The battery life estimation apparatus shown in FIG. 1 includes a measurement unit 2 that measures the voltage, current, temperature, and the like of a secondary battery 1 including one or a plurality of battery cells, an estimation unit 3, a data storage unit 4, a calculation unit 5, and a remaining life calculation unit 6. The estimation unit 3 estimates the battery characteristic (degradation state) at the present time based on the measurement data of the measurement unit 2. The data storage unit 4 stores a degradation characteristic map 41 representing the distribution of degradation constants with respect to the battery voltage and temperature, and use condition data 42 including a temperature time distribution, current value time distribution, and charge/discharge range in a battery use environment. The calculation unit 5 estimates the degradation amount of the battery characteristic based on the use condition data 42 and the degradation characteristic map 41 stored in the data storage unit 4. The remaining life calculation unit 6 calculates a remaining life until reaching the end condition of the battery life based on set use condition data.

### [Creation of Degradation Characteristic Map 41]

A degradation behavior as an electrode is represented by the sum of effects of the above-described three side reactions. A degradation speed as a battery is represented by the sum of the cathode and the anode. However, the degradation speed of the battery characteristic is not necessarily the sum of the three reactions. In the degradation reaction caused by electrolyte solution decomposition, a decrease in the capacity or increase in the internal resistance of the battery progresses due to the influence of the product coat or the like. The decrease in the capacity or increase in the internal resistance of the battery also progresses due to a decrease or inactivation of an active material in the active material degradation reaction as well. An active material causes the decrease in the capacity but not the increase in the internal resistance and vice versa. For this reason, individual formulas of the battery characteristic degradation speed such as the decrease in the capacity and the increase in the internal resistance are not the sum of the reactions. In addition, it is difficult to individually measure the reaction speeds of individual reactions by observing a change in the battery characteristic.

Hence, the degradation characteristic map 41 according to this embodiment can be obtained by measuring the degradation speed with respect to the temperature and the potential of each active material in the battery and creating the distribution state of the degradation constant on the potential-temperature plane. The degradation speed can be measured by creating an experimental cell for each active material, and conducting a float test that holds the cell to a predetermined potential or a storage test that sets the cell at a predetermined potential and then stores it while changing the temperature.

As the experimental cell, a three-pole cell using a counter electrode and a reference electrode made of metal lithium or a bipolar cell using an excessive cathode material or anode material as a counter electrode is preferably used. In the bipolar cell, the cathode material and the anode material used in the counter electrode are preferably materials of small degradation. More specifically, an example of the cathode material is lithium iron phosphate, and an example of the anode material is lithium titanate. As an advantage of these materials, few restrictions are imposed on usable electrolyte solutions.

As degradation tests, a float test that forcibly holds a predetermined potential and a storage test that sets a cell to a predetermined potential and then lets it stand can be used. In an overcharge region and an overdischarge region where a potential can hardly be held in an open state, the degradation speed is preferably measured by the float test. For a potential in a range where the battery is used in charge/discharge, either of the float test and storage test is usable. The potential range to measure the degradation speed characteristic is preferably wide to some extent, including the range corresponding to the cell use range. The test period of the float test or storage test is preferably one to four weeks. During this time, the temperature of the experimental cell needs to be kept constant using a thermostat or the like. The test needs to be conducted using test temperatures of at least three points which are preferably set within the range of 25°C to 65°C. It is necessary to test cells of the same potential conditions under these temperature conditions.

By conducting a degradation test under these conditions, an Arrhenius plot can be attained at temperatures of three or more points, and an activation energy can be calculated for active materials in the same potential state. To obtain a more correct degradation characteristic map, the potential conditions are preferably set to four or more points. At the end of each test period, the capacity value, the internal resistance value, and the like are measured at the reference temperature, for example, 25°C, and the gradient of degradation, that is, degradation speed in the storage period is evaluated. At this time, as a formula that describes the degradation behavior, a formula, selected from the square root law, first-order reaction formula, proportional expression, and other reaction formulas, and that matches the measured degradation behavior, can be used.

A method of measuring the degradation characteristic of an active material has been described above. As a simpler method, a degradation characteristic map can also be created by the float test or storage test using an actual cell. An actual cell is evaluated by the float or storage test using temperatures of three or more points and battery voltage conditions of four or more points, thereby creating a degradation characteristic map.

From the result of such a degradation characteristic test, the distribution state of degradation constants on a potential (or battery voltage)-temperature plane used in this embodiment is created. This distribution not only simply plots measurement results but also has a characteristic capable of continuously calculating degradation constants with respect to a temperature using the activation energy calculated by the Arrhenius plot.

### [About Use Condition Data 42]

In the secondary battery remaining life estimation method according to this embodiment, the residence time on the potential-temperature plane is calculated during the period for estimating the degradation amount of the battery, and the degradation amount is calculated by referring to the distribution state of degradation constants on the potential-temperature plane. Hence, in the remaining life estimation, two pieces of data, that is, the battery use conditions and the battery characteristic at the present time are necessary.

As the battery use conditions, three conditions, that is, temperature-time distribution, current value-time distribution, and charge/discharge range in the battery use environment are needed.

As the temperature-time distribution, the distribution of temperatures around the battery pack under the use environment is preferably used. Instead, the atmospheric temperature distribution in the battery use region may be used, or the battery temperature may be estimated in consideration of an operation condition of the battery.

The current value-time distribution need not be data that completely covers actual use in every case, and can be a current value-time distribution under average use conditions assumed in a device or vehicle. In the current distribution field, discharge, charge, and pause need to be discriminatively expressed. For example, it is possible to count a discharge current value as a negative value, a charge current value as a positive value, and a pause state as a current value of 0. If it is difficult to obtain the information of the current value-time distribution, the current value-time distribution of the battery can be calculated from the power value-time distribution of a device and used.

For the charge/discharge range (battery use SOC (State Of Charge) range) of the battery, a full charge condition and a full discharge condition are necessary. If battery control of a device is performed to limit charge/discharge for the sake of safety or to reduce degradation, the condition is preferably considered in the calculation to estimate a more correct residence time and life. As an example of such battery control, the charge end SOC is lowered depending on the battery temperature, or discharge is ended at a voltage higher than the battery capability.

### [About Estimation unit 3]

To evaluate the battery characteristic at the present time, a generally known battery characteristic measurement method is usable. More specifically, electrochemical measurements such as a charge/discharge test that actually supplies a current and measures the battery capacity, a current pause method that mainly measures the internal resistance value, and AC impedance measurement can be combined. When a method of simply estimating the battery characteristic by analyzing a charge/discharge curve as disclosed in patent literature 1 is used, the required evaluation can be done in little time and with little effort. This method is useful, although inferior in point of measurement accuracy to direct measurement. The simple measurement method as described above requires no special measurement device, and the user can evaluate the characteristic by himself/herself. Hence, this method is important from the viewpoint of allowing the user to do battery evaluation/life estimation for himself/herself.

### [About Calculation Unit 5]

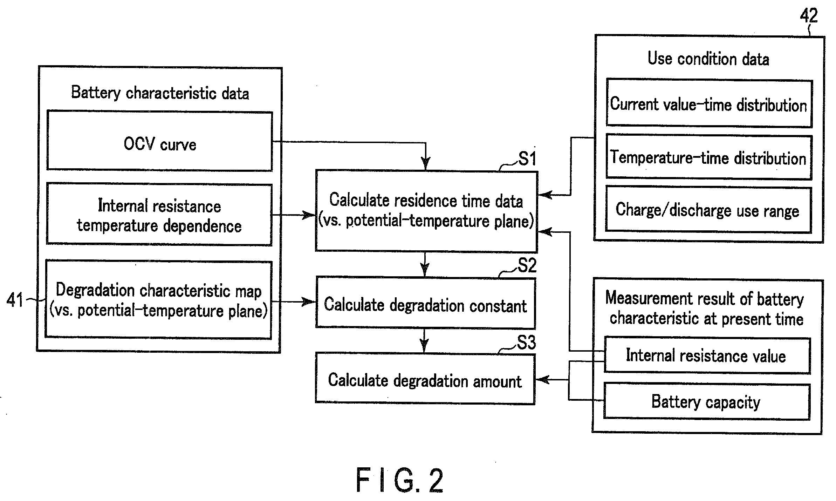

A battery remaining life estimation method according to this embodiment will be described next. FIG. 2 shows the processing procedure of the calculation unit 5.

### (Step S1: Residence Time Data Calculation)

First, the calculation unit 5 integrates residence times on the potential-temperature plane based on the use condition data 42 and the battery characteristic data at the present time. From the battery use charge/discharge range of the use condition data, an OCV (Open Circuit Voltage) curve within the battery use range is created. An internal resistance value is obtained from the battery characteristic measured at the evaluation time, and the residence time distribution on the potential-temperature plane is calculated from the temperature distribution and the current distribution. The temperature and current are assumed to be equivalently distributed. The potential of the battery is calculated by multiplying the current value and the internal resistance.

At this time, a change in the internal resistance value depending on temperature needs to be considered in the calculation. Under a low temperature, the internal resistance rises, and the overvoltage becomes large. Under a high temperature, the internal resistance lowers, and the overvoltage becomes small. Hence, the overvoltage is overestimated or underestimated especially in use with a large current. In particular, since the difference of the degradation amount generated by an error of the potential calculation value in a high-temperature range is large, the internal resistance needs to be corrected in association with the temperature. Temperature correction of the internal resistance can be performed simply using the change rate, by the temperature, of the internal resistance value of the battery in the initial state.

As a more accurate method, resistance components of the internal resistance may be measured, subjected to temperature correction in accordance with their internal resistance temperature dependences, and added. For example, open circuit potential-charge amount data of each active material is referred to from a charge/discharge curve (battery voltage-time, temperature data) under a predetermined battery condition, thereby evaluating the capacity, internal resistance, and degradation of each active material in the cathode/anode of the battery. At this time, each component of the internal resistance can separately be evaluated by referring to the resistance component-charge amount data of each active material. Major components of the internal resistance are ohmic resistance, reaction resistance, and diffusion resistance. This method includes the method of estimating the battery capacity and the internal resistance components by analyzing a charge/discharge curve, and has high compatibility with the battery remaining life estimation method according to this embodiment.

### (Step S2: Degradation Constant Calculation)

For the integrated residence time on the potential-temperature plane created in the above-described way, the calculation unit 5 refers to the degradation characteristic map on the potential-temperature plane for battery characteristics including at least the internal resistance value and capacity, and calculates the distribution state of degradation constants on the potential-temperature plane.

### (Step S3: Degradation Amount Calculation)

The calculation unit 5 refers to the distribution state of degradation constants on the potential-temperature plane, and estimates the degradation amount of each characteristic as the integral value on the entire plane.

In the battery life estimation method according to this embodiment, calculation of the internal resistance from the battery characteristics is a very important factor. This is because the potential of the battery when a current is applied is calculated by multiplication of the internal resistance, which affects estimation of the degradation amounts of all characteristics. As a method of improving the estimation accuracy, recursive calculation can be performed, which adds the effect of accelerating degradation by an increase in the overvoltage upon current application caused by an increase in the internal resistance along with the progress of battery degradation. The effect of accelerating the degradation speed by an increase in the internal resistance becomes conspicuous in a case where the current value is large, and the overvoltage is very large relative to the rate characteristic of the battery, and a case where the gradient of a change in the degradation speed with respect to the potential within the battery use range is large. In a case where the two conditions are met, recursive calculation is preferably performed concerning the internal resistance of the battery to calculate the residence time on potential-temperature.

This also applies to a cell temperature distribution. In a case where continuous charge/discharge is performed with a large current value relative to the rate characteristic of the battery and the heat dissipation capability of the battery pack, the battery temperature distribution rises during the period in which prediction is done due to an increase in Joule heat caused by an increase in the internal resistance. Hence, recursive calculation is preferably performed. In prediction over a long period of more than several years, the accuracy can largely be improved by dividing the period into several sections and performing calculation. Even in a case where there exists a clear change in the ambient temperature due to the season or the like, it is effective to divide the period, sequentially perform calculation, and integrate degradation amounts in order to more accurately perform the calculation. In recursive calculation or calculation by period division, calculation of the internal resistance from the battery characteristics is performed first. The residence time on potential-temperature on which the effect of resultant overvoltage shift and temperature rise is reflected is calculated, and a degradation amount is estimated by referring to the degradation characteristic map of each characteristic.

In the method according to this embodiment, bias in the residence SOCs is not taken into consideration, and all SOCs are assumed to be equivalent. This is because the purpose of estimation is remaining life calculation, and the time the battery stays in a region where the degradation constant abruptly increases is roughly calculated. By adding a condition that, for example, charge/discharge or storage near a specific SOC is large, more accurate estimation, including the behavior in the degradation process, can be performed.

### [About Remaining Life Calculation Unit 6]

Regarding the degradation behavior of a battery characteristic in actual use of a battery, degradation progresses with a predetermined degradation tendency according to the square root law, first-order reaction law, or the like during a certain period. Finally, degradation acceleration occurs in which the battery characteristic abruptly lowers, and the life expires. In this embodiment, the period from the present time can freely be set. The remaining life calculation unit 6 can obtain a remaining period assuming continuation of current use by setting a condition; for example, the life expires when a certain characteristic value falls below the lower limit value. Conversely, the remaining life calculation unit 6 can also estimate use conditions necessary for ensuring a specific use period.

As another method, use conditions necessary to use the battery for a longer period are adjusted. In the stage of abrupt degradation acceleration that occurs at the end of the life of a battery in use, overvoltage rise and battery temperature rise are assumed to be progressing due to an increase in the internal resistance. To use the battery while avoiding abrupt degradation, the use conditions can be adjusted based on the residence time data on potential-temperature of the battery according to the embodiment. That is, of the use conditions, the temperature condition or current condition may be relaxed to decrease the ratio at which the battery enters a region with a high degradation speed on the high temperature/high voltage side due to use in accordance with an increase in the internal resistance. For example, use of a device or vehicle in a low-temperature region or reuse of a battery in a device with a lower input/output value can be considered.

In such life estimation, expiration of the battery life is preferably set to a stage with a reserve to some extent, and the sign of abrupt degradation needs to be detected before the degradation acceleration occurs. For example, the remaining life calculation unit 6 can set the expiration of the life to a timing at which the ratio of entrance in a region where the degradation speed increases to a certain set value or more in the degradation speed data exceeds a certain ratio with respect to the unit time. Following setting can be done assuming that the life estimation according to this embodiment has been performed from the initial state of the battery. That is, the expiration of the life can be set to a timing at which the integrated time of entrance in a region where the degradation speed increases to a certain set value or more throughout the life of the battery increases to a predetermined value or more.

### [Description of Examples]

The secondary battery remaining life estimation method according to this embodiment will be described by exemplifying a battery including a cathode made of lithium cobalt oxide and an anode made of lithium titanate.

A degradation characteristic map was created by collecting results of a storage test and a float test of batteries. Detailed conditions of the tests are as follows. As the storage test, batteries whose battery OCVs were adjusted to 2.33 V, 2.35 V, 2.44 V, and 2.70 V were tested at temperatures of 25°C, 35°C, 45°C, and 55°C. As the float test, a test to hold batteries at battery voltages of 2.8 V and 1.5 V was conducted under 25°C, 35°C, and 45°C environments. In the tests, the 0.2C capacity and the 10s resistance at a current value of 5C for every SOC 10% within the SOC range of 10% to 90% were measured under the 25°C environment on a weekly basis during the first four weeks and, after that, once every three weeks.

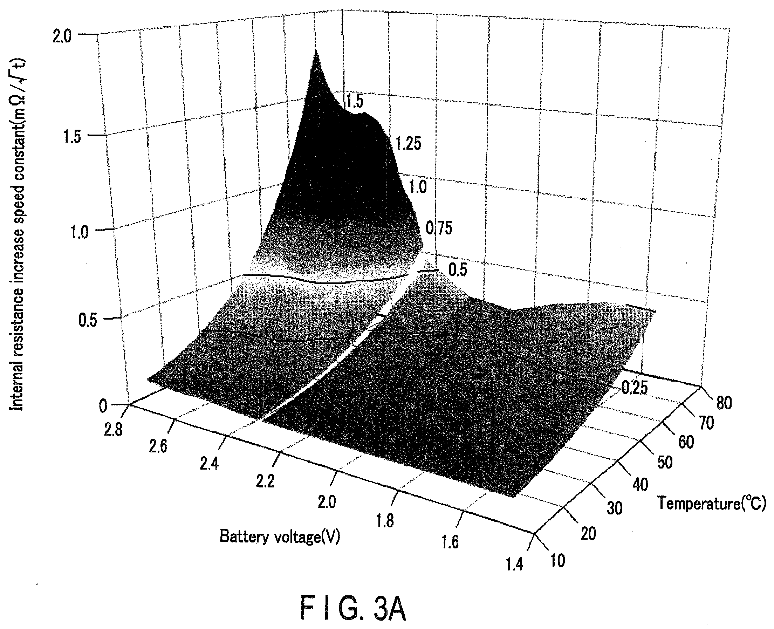

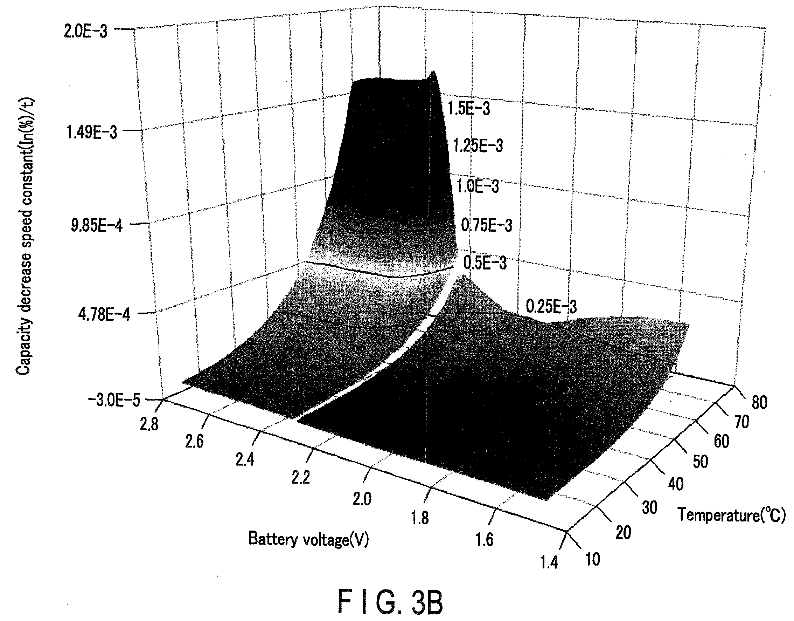

FIGS. 3A and 3B show degradation characteristic maps representing the distribution of the average values of internal resistance values and the distribution of battery capacity degradation speed coefficients, respectively, based on the results of the life tests. FIG. 3A shows internal resistance increase speed constants, plotting the cell voltage along the X-axis, the temperature along the Y-axis, and the degradation speed along the Z-axis. FIG. 3B shows capacity decrease speed constants, plotting the cell voltage along the X-axis, the temperature along the Y-axis, and the degradation speed along the Z-axis. As for the degradation speed formula, the square root law was employed for the internal resistance value, and the first-order reaction formula was employed for the decrease in the capacity.

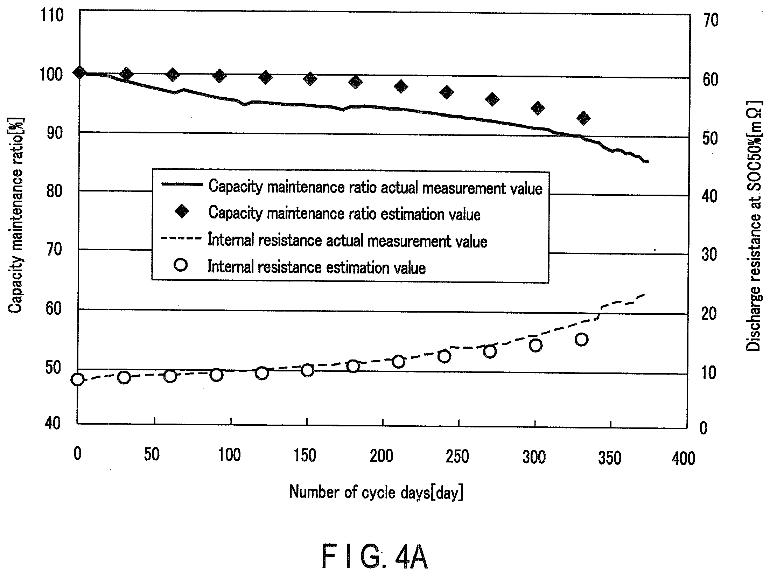

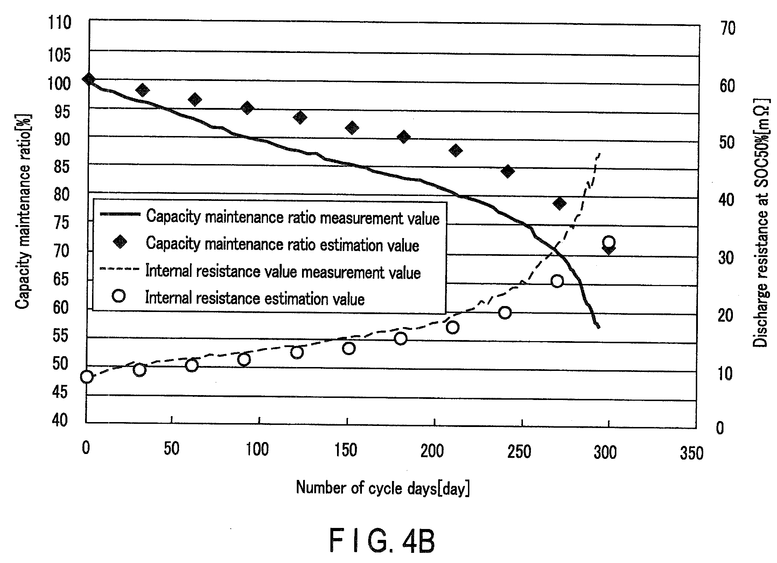

As for the use conditions, two simple conditions for conformation of the estimation principle, that is, 5C constant current charge/discharge cycle under the 25°C environment and that under the 45°C environment will be exemplified. In this case, as the current value-time distribution conditions, 50% (discharge) at -5C and 50% (charge) at +5C are commonly used. The temperature-time distribution conditions are constant at 25°C and 45°C. Each of FIGS. 4A and 4B shows, together with the actual measurement values, results obtained by diving the period every 30 days from the initial state based on the conditions and estimating the degradation amounts of the internal resistance and capacity while updating the internal resistance and temperature. FIG. 4A is a graph showing the estimation results of the internal resistance and capacity in the 25°C 5C cycle. FIG. 4B is a graph showing the estimation results of the internal resistance and capacity in the 45°C 5C cycle. The actual measurement values and estimated values generally exhibit good matching. In the 45°C cycle shown in FIG. 4B, the time at which degradation accelerates also matches the actual measurement value.

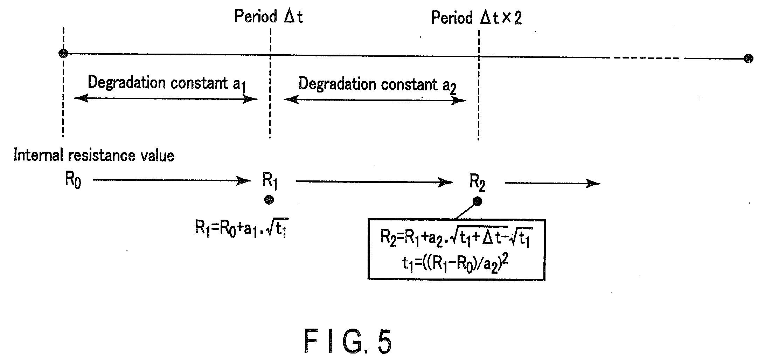

Note that in estimation of the degradation amount by the square root law or first-order reaction law, a degradation amount R₂ is calculated using average degradation speed constants a₁, a₂,..., when the use period is divided by Δt, as shown in FIG. 5, and time initial values R₀, R₁,..., calculated from the degradation amount up to the section starting point. In the speed formula of the square root law or first-order reaction law, the degradation amount is not determined only by the time Δt, and the starting point of Δt (t₁ in FIG. 5) is needed. The value of t₁ is calculated, by an equation in the box of FIG. 5, using the degradation constant a₂ in the section where the degradation amount is calculated with respect to the degradation amount R₁ up to the preceding section.

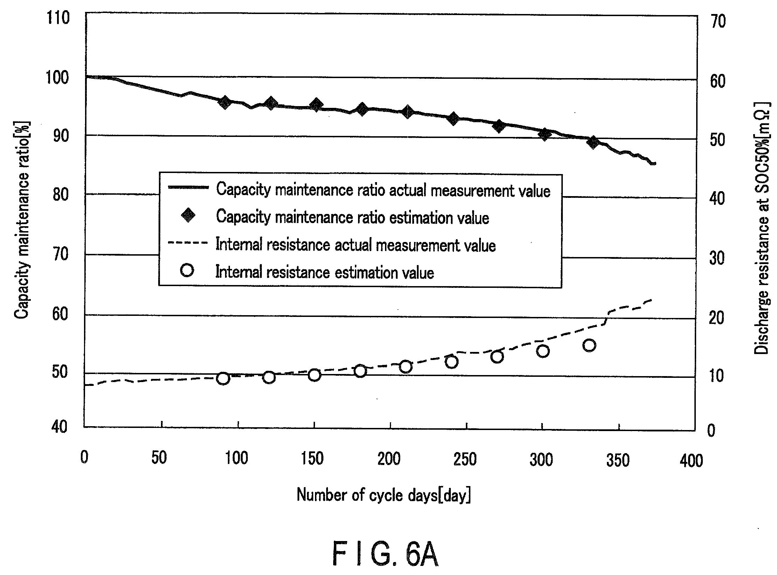

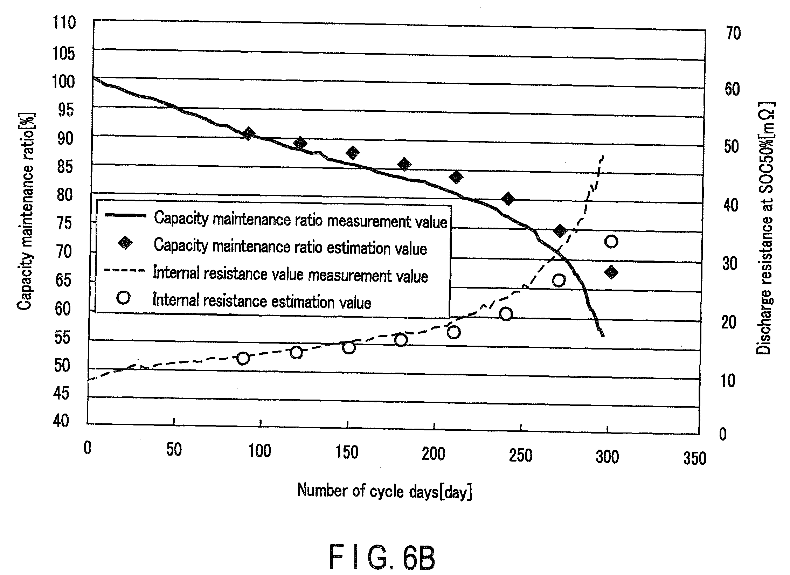

FIGS. 6A and 6B show results obtained by performing estimation by setting a point of the elapse of about three months as the starting point in estimation of the conditions. FIG. 6A is a graph showing the estimation results of the internal resistance and capacity in the 25°C 5C cycle. FIG. 6B is a graph showing the estimation results of the internal resistance and capacity in the 45°C 5C cycle. Good matching with the actual measurement values is exhibited, like the results shown in FIGS. 4A and 4B. It can be confirmed that estimation halfway through use is also effective.

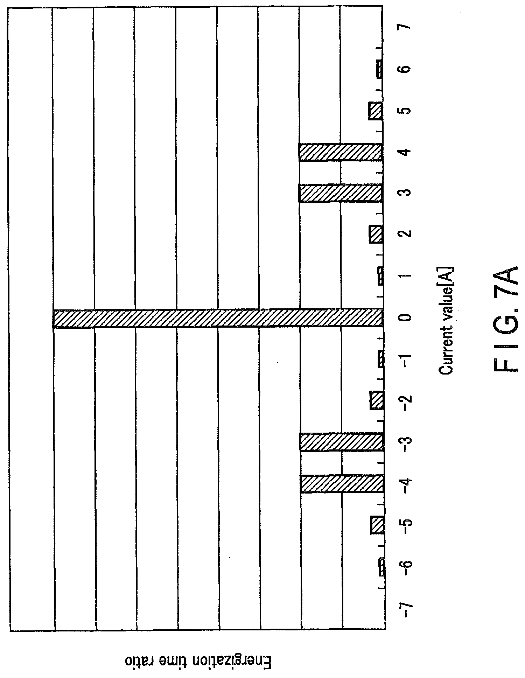

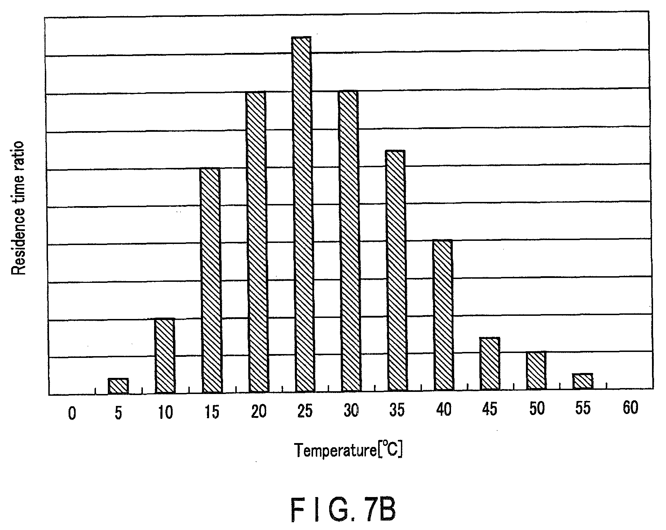

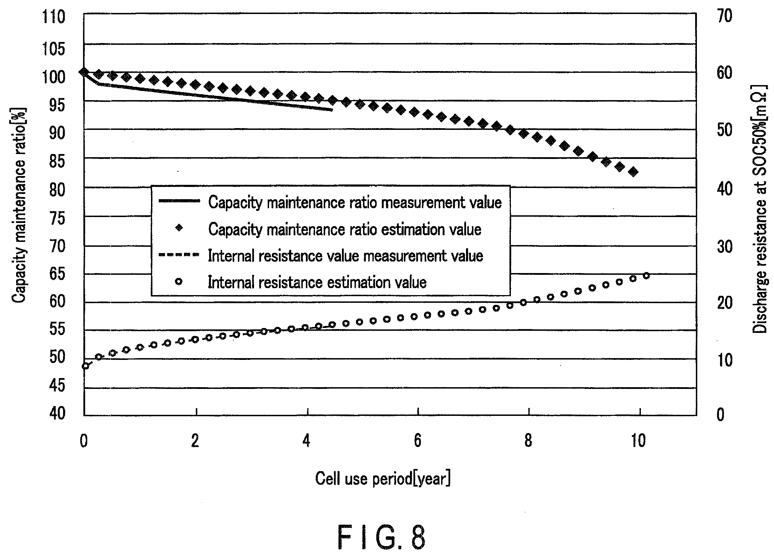

FIG. 8 shows results obtained by performing life estimation under the use conditions shown in FIGS. 7A and 7B. For the current value-time distribution shown in FIG. 7A and the temperature-time distribution shown in FIG. 7B, the period is divided every three months, the internal resistance is updated sequentially, and the estimation is performed. As shown in FIG. 8, the actual measurement values were not acquired because of a long life over five or more years. It can be predicted that the characteristic should start abruptly decreasing, and battery use should become impossible when a little over eight years has elapsed.

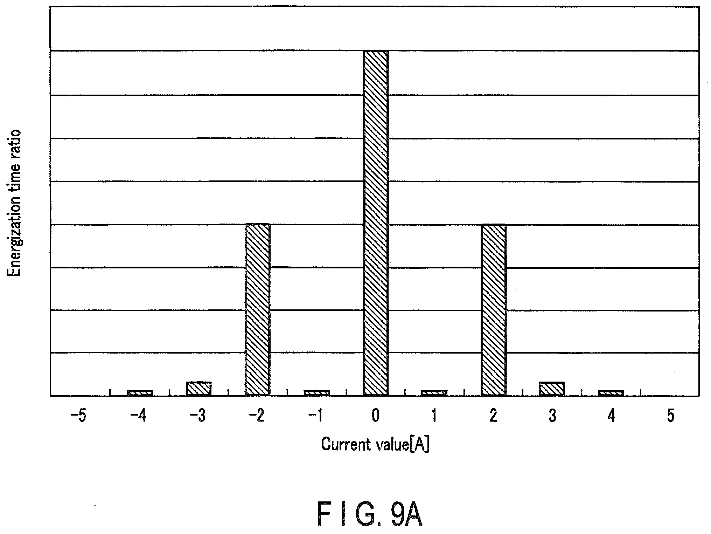

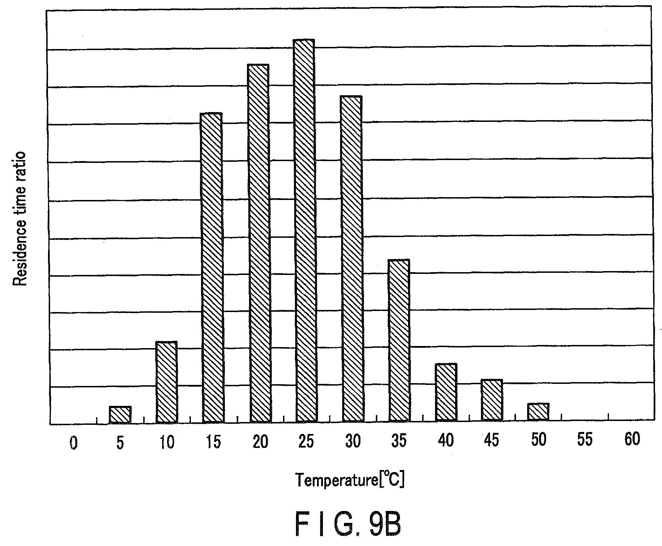

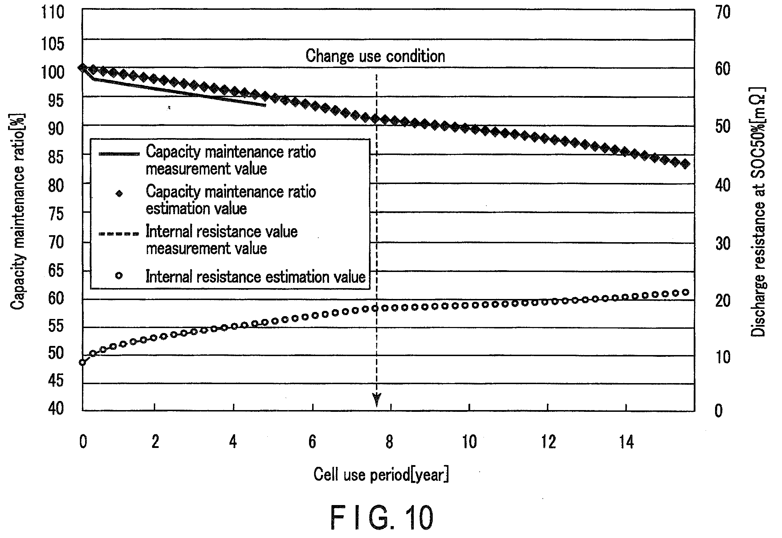

FIG. 10 shows an estimation result when the use conditions were changed to the current value-time distribution shown in FIG. 9A and the temperature-time distribution shown in FIG. 9B in seven years. According to the prediction in this case, the possibility that the battery is usable up to the 13th year in the estimation can be found. According to the battery remaining life estimation method of this embodiment, it is assumed to contribute to effective utilization of a battery by adjusting the battery use conditions, as shown in FIG. 10.

It should be noted that the present inventions are not limited to the above embodiments and may be embodied in various modifications to the structural elements without departing from the spirit of the inventions. Furthermore, the structural elements in any embodiment of the above may be suitably combined to achieve various inventions. For example, some of the structural elements may be removed from the structures of the above embodiments. Moreover, structural elements of different embodiments may be suitably combined.

## Claims

1. A battery life estimation method comprising:
calculating, for a secondary battery, battery characteristic data at a present time including at least an internal resistance value;
storing use condition data including a temperature-time distribution and a current value-time distribution during an estimation period and a degradation characteristic map representing a distribution of degradation constants with respect to battery voltages and temperatures; and
estimating a degradation amount by integrating residence times on a battery voltage-temperature plane in the degradation characteristic map based on the battery characteristic data at the present time and the use condition data.

2. The battery life estimation method of claim 1, wherein recursive calculation is performed for an increase in the internal resistance value.

3. The battery life estimation method of claim 1, wherein the period to estimate the battery characteristic is divided into a plurality of sections, and the degradation amount is estimated while updating the battery characteristic in each section for the use condition data in each section.

4. The battery life estimation method of any one of claims 1 to 3, wherein the degradation characteristic map is obtained by estimating a behavior of the degradation constant with respect to the battery voltage and the temperature from a degradation constant of a potential and a temperature of an active material in the battery.

5. The battery life estimation method of any one of claims 1 to 4, wherein in the degradation characteristic map, a battery voltage-temperature region where the degradation constant is not less than a predetermined value is defined, and a period in which an integrated time of placement of the battery in the region exceeds a predetermined period is calculated as a remaining life from the use condition data by calculation.

6. The battery life estimation method of any one of claims 1 to 4, wherein in the degradation characteristic map, a battery voltage-temperature region where the degradation constant is not less than a predetermined value is defined, and a period in which a ratio of a time of placement of the battery in the region exceeds a predetermined value is calculated as a remaining life from the use condition data by calculation.

7. The battery life estimation method of any one of claims 1 to 4, wherein a remaining life is calculated as a period until reaching a lower limit of each battery performance.

8. The battery life estimation method of any one of claims 1 to 7, wherein a use condition to make the battery usable for a predetermined period is calculated for the battery characteristic at the present time.

9. A battery life estimation apparatus comprising:
an estimation unit configured to calculate, for a secondary battery, battery characteristic data at a present time including at least an internal resistance value;
a storage unit configured to store use condition data including a temperature-time distribution and a current value-time distribution during an estimation period and a degradation characteristic map representing a distribution of degradation constants with respect to battery voltages and temperatures; and
a calculation unit configured to estimate a degradation amount by integrating residence times on a battery voltage-temperature plane in the degradation characteristic map based on the battery characteristic data at the present time and the use condition data.
